(19) Europäisches Patentamt / European Patent Office / Office européen des brevets

(11) **EP 1 689 074 B1**

(12) **EUROPEAN PATENT SPECIFICATION**

(45) Date of publication and mention of the grant of the patent:
**17.10.2012 Bulletin 2012/42**

(51) Int Cl.:
***H03B 5/12*** *(2006.01)*

(21) Application number: **06002180.5**

(22) Date of filing: **02.02.2006**

(54) **Ultra wide band signal generator**

Ultrabreitband-Signalgenerator

Générateur des signaux à bande très large

(84) Designated Contracting States:
**DE FI FR GB IT SE**

(30) Priority: **02.02.2005 US 649285 P**
**03.05.2005 KR 2005037291**

(43) Date of publication of application:
**09.08.2006 Bulletin 2006/32**

(73) Proprietors:
• **Samsung Electronics Co., Ltd.**
**Suwon-si, Gyeonggi-do, 443-742 (KR)**
• **GEORGIA TECH RESEARCH CORPORATION**
**Atlanta, GA 30332-0415 (US)**

(72) Inventors:
• **Mukhopadhyay, Rajarshi**
**Atlanta**
**Georgia 30332 (US)**
• **Nuttinck, Sebastian**
**Atlanta**
**Georgia 30332 (US)**
• **Park, Yun-Seo**
**Atlanta**
**Georgia 30329 (US)**
• **Yoon, Sang-Woong**
**Atlanta**
**Georgia 30332 (US)**
• **Woo, Sang-Hyun**
**Yeongtong-gu**
**Suwon-si**
**Gyeonggi-do (KR)**
• **Kang, Hyun-Il**
**Yeongtong-gu**
**Suwon-si**
**Gyeonggi-do (KR)**
• **Lee, Chang-Ho**
**Georgia 30062 (US)**
• **Laskar, Joy**
**Georgia 30328 (US)**

(74) Representative: **Grünecker, Kinkeldey,**
**Stockmair & Schwanhäusser**
**Leopoldstrasse 4**
**80802 München (DE)**

(56) References cited:
**US-A- 5 347 238    US-A- 5 821 825**

• **PATENT ABSTRACTS OF JAPAN vol. 1996, no. 07, 31 July 1996 (1996-07-31) & JP 08 065050 A (SONY CORP), 8 March 1996 (1996-03-08)**
• **KOBAYASHI K W ET AL: "A NOVEL SELF-OSCILLATING HEMT-HBT CASCODE VCO-MIXER USING AN ACTIVE TUNABLE INDUCTOR" IEEE JOURNAL OF SOLID-STATE CIRCUITS, IEEE SERVICE CENTER, PISCATAWAY, NJ, US, vol. 33, no. 6, June 1998 (1998-06), pages 870-875, XP000833665 ISSN: 0018-9200**
• **MING-JUEI WU ET AL: "A constant power consumption CMOS LC oscillator using improved high-Q active inductor with wide tuning-range" CIRCUITS AND SYSTEMS, 2004. MWSCAS '04. THE 2004 47TH MIDWEST SYMPOSIUM ON HIROSHIMA, JAPAN JULY 25-28, 2004, PISCATAWAY, NJ, USA,IEEE, vol. 3, 25 July 2004 (2004-07-25), pages III347-III350, XP010738954 ISBN: 0-7803-8346-X**
• **CHO Y-H ET AL: "A NOVEL ACTIVE INDUCTOR AND ITS APPLICATION TO INDUCTANCE-CONTROLLED OSCILLATOR" IEEE TRANSACTIONS ON MICROWAVE THEORY AND TECHNIQUES, IEEE SERVICE CENTER, PISCATAWAY, NJ, US, vol. 45, no. 8, PART 1, August 1997 (1997-08), pages 1208-1213, XP000697478 ISSN: 0018-9480**

**Description**

The present invention relates to a signal generator, and more particularly to a signal generator for generating a signal at a required frequency using a harmonic signal having a frequency range in the ultra wide band (UWB).

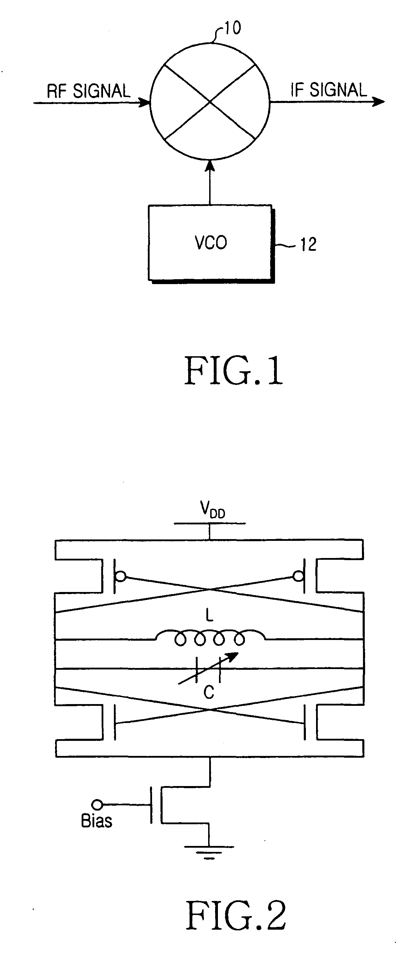

In a wireless communication system, a radio frequency (RF) signal received in a receiver is converted into an intermediate frequency (IF) signal by means of a mixer 10 as shown in FIG. 1. The mixer 10 mixes a signal delivered from a voltage controlled oscillator (VCO) 12 with the RF signal and converts the frequency of the mixed signal into the frequency of the IF signal.

As described above, the VCO included in the receiver is mainly used for channel selection. In order to be used for band selection, the VCO must have a wider frequency control range.

However, the conventional VCO shown in FIG. 2 cannot control a wide frequency range using only a varactor because a great number of parasitic capacitors exist in the VCO.

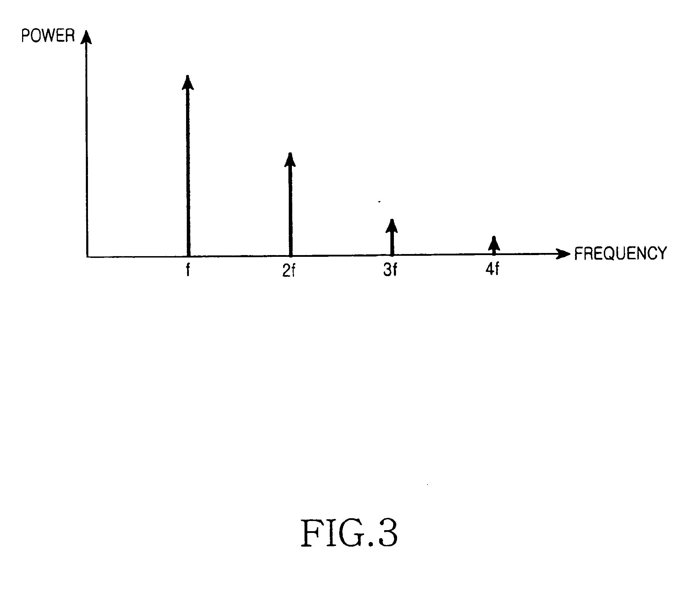

As shown in FIG. 3, a non-linear element generates harmonics with respect to a fundamental frequency f, and these harmonics are generated in a wide frequency band. Since these harmonics have very little power, the harmonics are unsuitable for oscillator signals.

US-A-5,821,825 discloses an optically controlled oscillator utilizing a high electron mobility transistor, HEMT, or a heterojunction bipolar transistor, HBT, or a combination thereof, as an active inductor. This inductor is used for tuning a frequency of an oscillator.

JP 08065050 A discloses an oscillator with the fundamental wave generation circuit for generating fundamental waves including higher harmonics. The oscillator is said to be capable of using the higher harmonics of not only an odd order but also even order and even using higher harmonics of a still higher order.

US-A-5,347,238 discloses a voltage controlled oscillator with tunable active inductors for tuning a frequency of oscillation.

It is the object of the present invention to provide a signal generator for generating harmonic signals in a frequency range of an ultra wide band and outputting a harmonic signal having a desired frequency using a harmonic signal at a power level high enough to be used as an oscillator signal.

This object is solved by the subject matter of the independent claims.

Preferred embodiments are defined in the dependent claims.

An aspect of the present invention is to provide a signal generator for generating harmonic signals at a power level high enough to be used as oscillator signals, using a tunable active inductor (TAI) and outputting a harmonic component having a desired frequency using a filter.

The present invention will be more apparent from the following detailed description taken in conjunction with the accompanying drawings, in which:

FIG. 1 illustrates an internal structure of a receiver in the conventional wireless communication system;
FIG. 2 illustrates the conventional VCO circuit diagram;
FIG. 3 is a graph illustrating power of general harmonics;
FIG. 4 is a circuit diagram illustrating an ultra wide band signal generator according to a first embodiment of the present invention;
FIG. 5 is a circuit diagram equivalent to a filter module shown in FIG. 4;
FIG. 6 is a circuit diagram illustrating an example of a TAI shown in FIG. 4;
FIG. 7 is a graph illustrating power of harmonics according to an input voltage of a TAI shown in FIG. 4;
FIG. 8 is a view for explaining harmonics output from an oscillator shown in FIG. 4;
FIG. 9 is a graph illustrating that a harmonic signal having a corresponding frequency is selected by a variable capacitor $C_{load}$ of a filter module shown in FIG. 4;
FIG. 10 is a circuit diagram illustrating an ultra wide band signal generator according to the second embodiment of the present invention;
FIG. 11 illustrates output power according to frequencies with respect to a signal generator shown in FIG. 4; and
FIG. 12 illustrates a phase noise according to the change of a fundamental frequency with respect to a signal generator shown in FIG. 4.

Hereinafter, preferred embodiments of the present invention will be described in detail with reference to the accompanying drawings. Note that the same or similar components in drawings are designated by the same reference numerals as far as possible although they are shown in different drawings. In the following description of the present invention, a detailed description of known functions and configurations incorporated herein will be omitted when it may make the subject matter of the present invention unclear.

An ultra wide band signal generator according to the present invention includes a tunable active inductor (TAI) for generating harmonic signals having an ultra wide band, an oscillator 42 for generating harmonic signals by using non-linear elements, and a filter module 41 for selecting and outputting a signal having a corresponding frequency from among the harmonic signals having the ultra wide band output from the oscillator 42.

The TAI can tune an inductor value thereof and is connected to a base of a transistor Q1 of the oscillator 42 through a capacitor C3.

The oscillator 42 includes the transistor Q1, a bias voltage Bias is input to the base of the transistor Q1 through a resistor R1, and capacitors C1 and C2 are interposed between ground and the base of the transistor of Q1. A current source $I_{core}$ is connected to an emitter of the transistor Q1, and with capacitors C1 and C2. In addition, an Inductor $L_{load}$ connected to a voltage source VDD and a capacitor C4 connected to an output port OUT are linked with a collector of the transistor Q1. The oscillator 42 having the above structure can output the harmonic signal input thereto from the TAI by shifting the frequency band of the harmonic signal into the frequency band of the high frequency signal generated from the oscillator 42.

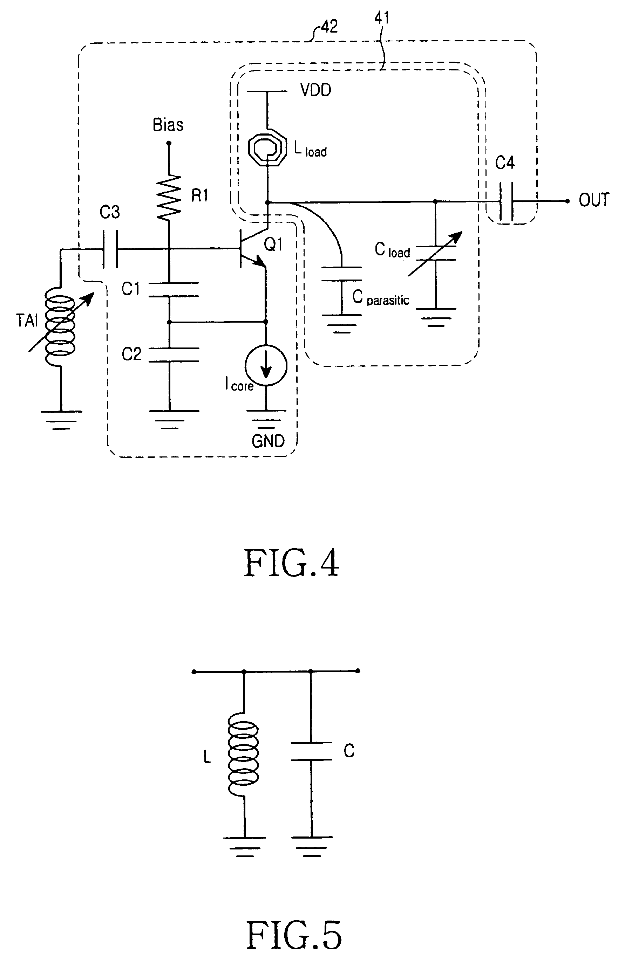

The filter module 41 is realized in such a manner that a variable capacitor $C_{load}$ such as a varactor is interposed between the collector of the transistor Q1 and ground so as to select together with the inductor $L_{load}$ a signal having a corresponding frequency from among harmonic signals output from the collector of the transistor Q1. The filter module 41 includes a parasitic capacitor $C_{parasitic}$ as shown in FIG. 4. This allows the filter module 41 to be equivalent to a filter including an inductor L and a capacitor C shown in FIG. 5.

Hereinafter, description about the TAI will be given in more detail.

The TAI generates harmonic signals within a non-linear operation range. Conventionally, since harmonic signals generated from the TAI actually have power of very little strength, it is impossible for the harmonic signals to be used in an oscillator. The present invention increases the strength of the power input to the TAI in order to generate harmonic signals having power which can be used for the oscillator 42. If the strength of a voltage input to the TAI is increased, the strength of power of generated harmonic signals is increased. In addition, when the power of an input voltage is strong, the power of harmonic signals has strength approximate to each other.

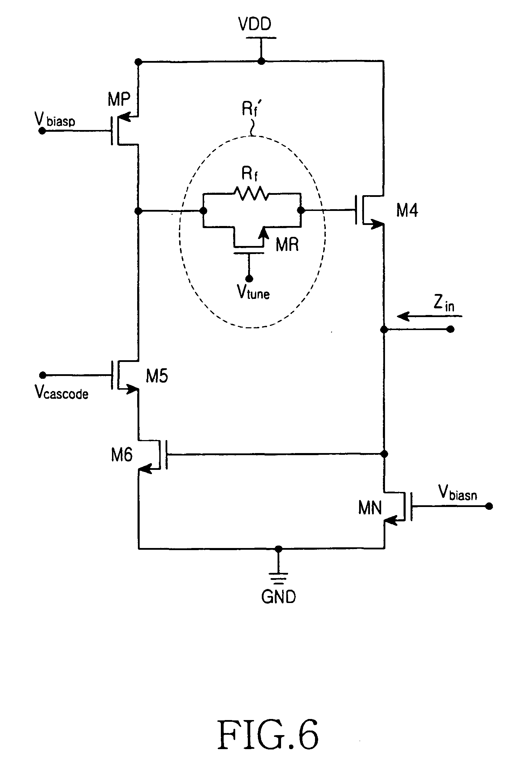

FIG. 6 is a circuit diagram illustrating an example of the TAI.

The TAI shown in FIG. 6 includes a tunable feedback resistor in a Cascode-Grounded structure. That is, in a Gyrator structure constructed by a transistor M4 and a transistor M6, the TAI has a transistor M5 connected to a transistor M6 in a Cascode-Grounded structure and a tunable feedback resistor $R'_f$ interposed between a drain of the transistor M5 and a gate of a transistor M4. A transistor MP operates as a current source in a PMOS type, and a transistor MN operates as a current source in an NMOS type. The tunable feedback resistor $R'_f$ includes a resistor $R_f$ and the transistor MR.

Herein, on the assumption that the value of the $R'_f$ is obtained through Equation 1, a factor Q, a peak frequency $f_Q$ of the factor Q, and a self-resonance frequency $\omega$ are obtained through Equations 2 to 4, respectively.

$$R'_f \approx \frac{R_f}{1 + R_f\, g_{dsR}} \qquad \ldots\ldots(1)$$

Herein, the $g_{dsR}$ denotes an output conductance for the transistor MR.

$$Q \approx \frac{\omega[C_{gs5}(g_{ds5}+g_{dsP})+C_{gs4}g_{mN}(1+2R'_f g_{dsP})-\omega^2 C_{gs4}{}^2 C_{gs5} R'_f\{1+R'_f(g_{ds5}+g_{dsP})\}]}{[g_{mN}g_{dsP}+g_{ds6}(g_{ds5}+g_{dsP})-\omega^2 C_{gs4}\{C_{gs5}(1+2R'_f(g_{ds5}+g_{dsP}))+C_{gs4}(1+2R'_f g_{dsP})\}]} \qquad \ldots\ldots(2)$$

Herein, the $g_{ds5}$, the $g_{ds6}$, and the $g_{dsP}$ denote output conductances for the transistors of M5, M6, and MP, respectively, and the $C_{gs4}$ and the $C_{gs5}$ denote capacitances between the gates and the sources of the transistors M4 and M5, respectively. The $g_{mM}$ denotes a mutual conductance of the transistor MN, and the $\omega$ denotes a self-resonance frequency.

$$f_Q \approx \frac{1}{2\pi} \sqrt{\frac{g_{mN}\, g_{dsP} + g_{ds6}(\, g_{ds5} + g_{dsp})}{C_{gs4}\, \{C_{gs4}\, (1+(R'_f\, g_{dsP})+C_{gs5}\, (1+2R'_f\, (g_{ds5}+g_{dsP}))\}}} \qquad \ldots\ldots(3)$$

$$\omega \approx \sqrt{\frac{C_{gs5}(g_{ds5}+g_{dsP})+C_{gs4}g_{mN}(1+2R'_f\, g_{dsP})}{C_{gs4}{}^2 C_{gs5} R'_f\, \{1+R'_f\, (g_{ds5}+g_{dsP})\}}} \qquad \ldots\ldots(4)$$

It can be understood from Equations 2 to 4 that the TAI according to the present invention constantly maintains the factor Q, the peak frequency $f_Q$ of the factor Q, and the self-resonance frequency $\omega$ by tuning the value of the $g_{dsP}$ even when the value of the $R'_f$ increases.

Since the tunable feedback resistor $R'_f$ includes the resistor $R_f$ and the transistor MR, the intensity of the $R'_f$ can be tuned by controlling the voltage $V_{tune}$ connected to the gate of the transistor MR. The value of the $g_{dsP}$ is tuned by controlling the $V_{biasp}$ connected to the gate of the transistor MP.

In other words, the value of the TAI can be tuned through the combination of the $V_{biasp}$, the $V_{tune}$, and the $V_{biasn}$.

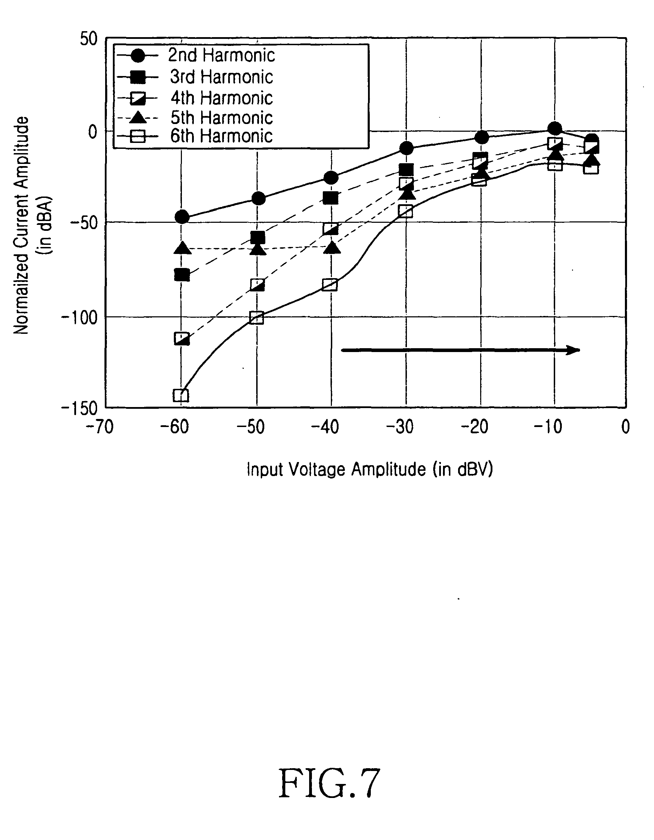

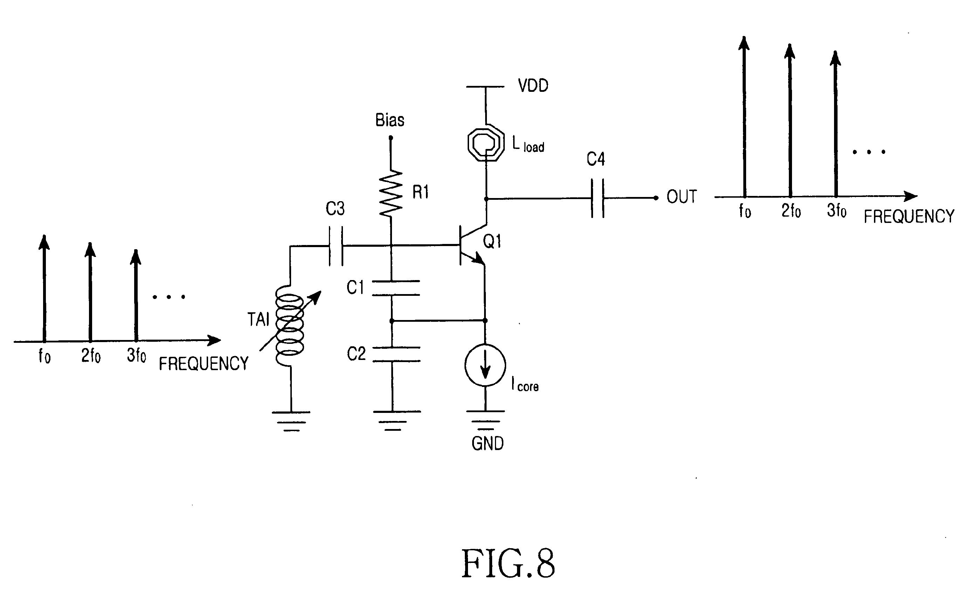

It can be understood that the power of harmonic signals according to an input voltage of the TAI having the above structure may increase and converge into a predetermined value as the input voltage increase as shown in FIG. 7. The present invention uses the above described principle. Accordingly, all harmonic signals having an ultra wide band generated from the oscillator 42 excluding the variable capacitor $C_{load}$ of the filter module 41 shown in FIG. 4 are shown in FIG. 8. In other words, it can be understood from FIG. 8 that harmonic signals having power similar to each other and being generated from the TAI are amplified by the oscillator 42 so that harmonic signals having stronger power are output. As described above, according to the present invention, harmonic signals having an ultra wide band are generated using the TAI.

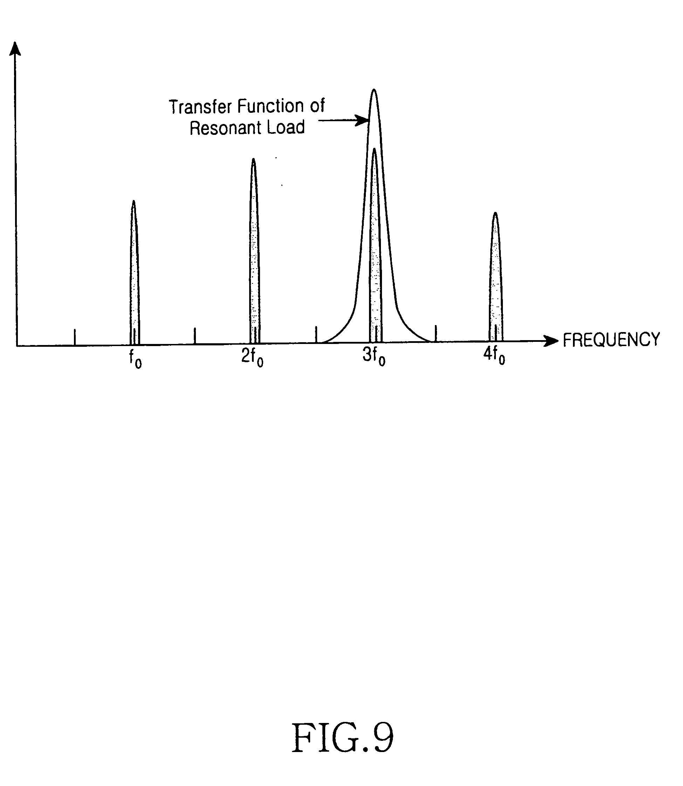

FIG. 9 is a graph illustrating that the filter module 41 shown in FIG. 4 selects a harmonic signal having a corresponding frequency by using the variable capacitor $C_{load}$. As shown in FIG. 9, it can be understood that the filter module 41 shown in FIG. 4 selects and outputs the harmonic signal having the corresponding frequency from among harmonic signals having an ultra wide band output from the oscillator 42 by means of a transfer function of resonant load of the filter module 41.

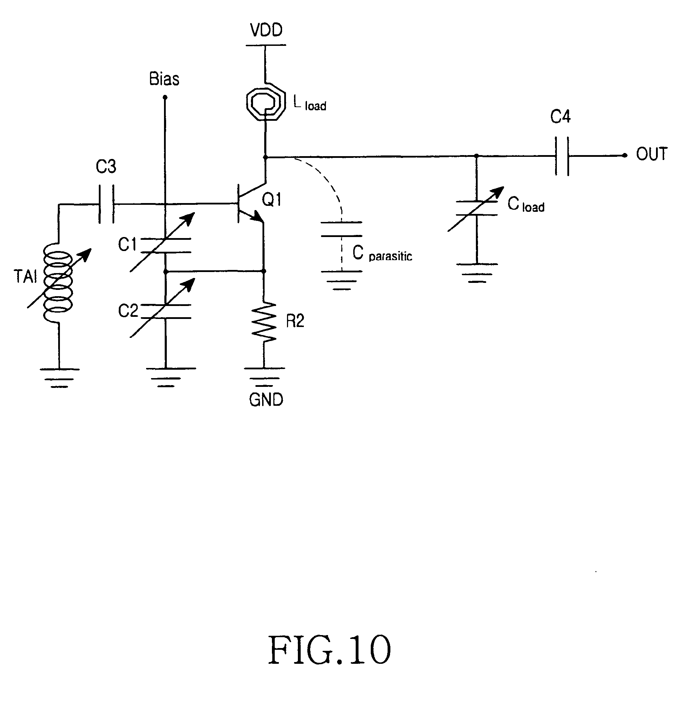

In the meantime, in the signal generator shown in FIG. 4, the resistor R1 connected to the bias voltage Bias is removed, variable capacitors are employed instead of the capacitors C1 and C2, and a resistor R2 is employed instead of the current source $I_{core}$, thereby enabling the realization of a signal generator shown in FIG. 10 according to another embodiment of the present invention.

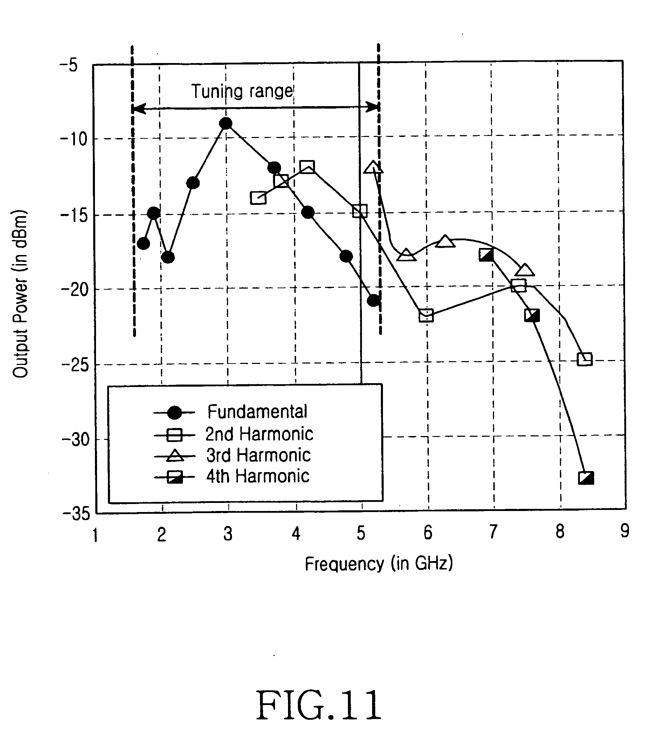

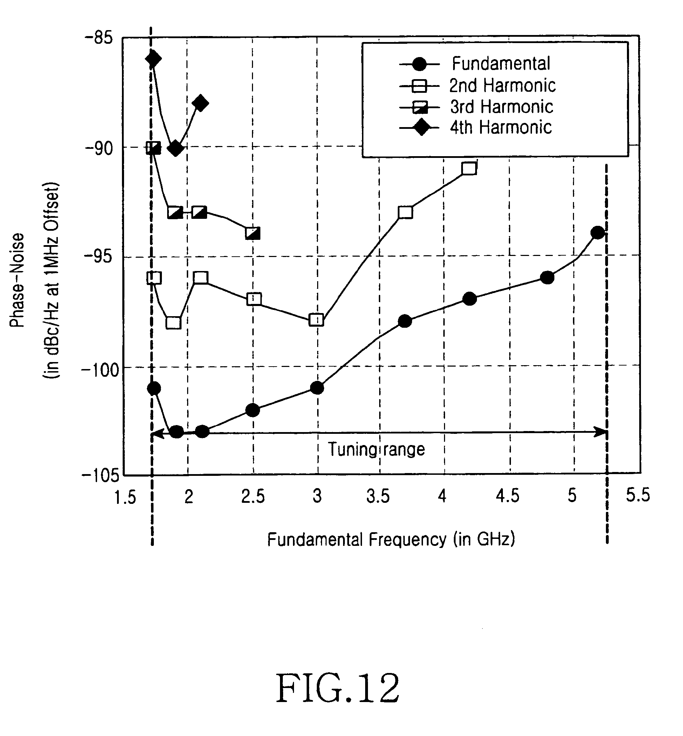

FIGs. 11 and 12 are graphs illustrating simulation results of the ultra wide band signal generator according to the present invention. FIG. 11 illustrates output power according to frequencies, and FIG. 12 illustrates a phase noise according to the change of a fundamental frequency. FIG. 11 illustrates that the fundamental frequency must be controlled within the range of about 1.7GHz to 5.2GHz in order to use the harmonic signals having output power of a fundamental frequency level. FIG. 12 illustrates frequency ranges and phase noises of fundamental frequencies and harmonic signals according to the fundamental frequencies. As shown in FIG. 12, it can be understood that it is more efficient to use a harmonic signal having low intensity instead of a fundamental frequency having strong intensity under the condition of the same phase noise.

As described above, according to the present invention, it is possible to provide a signal generator for generating harmonic signals having an ultra wide band using a tunable active inductor and selecting and outputting a harmonic signal having a corresponding frequency by means of a filter, thereby enabling the control of a frequency of the generated signal within the range of the ultra wide band.

While the invention has been shown and described with reference to certain preferred embodiments thereof, it will be understood by those skilled in the art that various changes in form and details may be made therein without departing from the scope of the invention. Consequently, the scope of the invention should not be limited to the embodiments, but should be defined by the appended claims.

**Claims**

1. A signal generator comprising an active inductor for generating harmonic signals, an oscillator for outputting the harmonic signals generated from the active inductor,

   wherein the signal generator is an ultra wide band signal generator with the active inductor, referred to as TAI, Tunable Active Inductor, adapted to generate the harmonic signals with power strengths substantially equal to each other within a non-linear operating range, the tunable active inductor being capable of tuning a value thereof, the oscillator(42) adapted to amplify the harmonic signals by frequency-transiting harmonic signals into high frequency bands; and a filter (41) adapted to selectively output one of the harmonic signals output from the oscillator,

   **characterized in that** the active inductor comprises:

   a first transistor(MP) having a source connected to a voltage source and a gate connected to a first bias voltage;
   a second transistor(M5) having a drain connected to a drain of the first transistor and a gate connected to a second bias voltage;
   a third transistor(M6) having a drain connected to a source of the second transistor and a source connected to ground;
   a fourth transistor(MN) having a drain connected to a gate of the third transistor, a source connected to the ground, and a gate connected to a third bias voltage;
   a fifth transistor(M4) having a source connected to the drain of the fourth transistor and a drain connected to the voltage source; and
   a first tunable resistance($R_f'$) interposed between the drain of the first transistor and a gate of the fifth transistor, and comprised a first resistor($R_f$) and a sixth transistor(MR).

2. The signal generator as claimed in claim 1, wherein the first resistor is interposed between the drain of the first transistor and the gate of the fifth transistor, and the sixth transistor has a drain connected to the drain of the first transistor, a source connected to the gate of the fifth transistor, and a gate connected to a fourth bias voltage.

3. The signal generator as claimed in one of claims 1 to 2, wherein the oscillator comprises:

   a seventh transistor having a base connected to the tunable active inductor;
   a first capacitor interposed between the tunable active inductor and the seventh transistor;
   a third resistor interposed between a fifth bias voltage and the base of the transistor;
   a second capacitor interposed between the base of the seventh transistor and an emitter of the seventh transistor;
   a third capacitor interposed between ground and the second capacitor;
   a first current source interposed between the emitter of the seventh transistor and ground;
   a first inductor interposed between a voltage source and a collector of the seventh transistor; and
   a fourth capacitor interposed between the collector of the seventh transistor and an output port.

4. The signal generator as claimed in claim 3, wherein the filter performs filtering by using the first inductor and a first variable capacitor interposed between the collector of the seventh transistor and ground.

5. The signal generator as claimed in one of claims 1 to 4, wherein the oscillator comprises:

   an eighth transistor having a base interposed between the tunable active inductor and a sixth bias voltage;
   a fifth capacitor interposed between the tunable active inductor and the eighth transistor;
   a second variable capacitor interposed between the base of the eighth transistor and an emitter of the eighth transistor;
   a third variable capacitor interposed between the second variable capacitor and ground;
   a fourth resistor interposed between the emitter of the eighth transistor and ground;
   a second inductor interposed between the voltage source and the collector of the eighth transistor; and
   a sixth capacitor interposed between the collector of the eighth transistor and the output port.

6. The signal generator as claimed in claim 5, wherein the filter performs filtering by using the second inductor and a fourth variable capacitor interposed between the emitter of the eighth transistor and ground.

**EP 1 689 074 B1**

**Patentansprüche**

1. Signalgenerator, umfassend einen Aktivinduktor zum Erzeugen von harmonischen Signalen, und einen Oszillator zum Ausgeben der von dem Aktivinduktor erzeugten harmonischen Signale,

   wobei der Signalgenerator ein Ultrabreitbandsignalgenerator ist, dessen als abstimmbarer Aktivinduktor TAI (Tunable Active Inductor) bezeichneter Aktivinduktor ausgelegt ist zum Erzeugen der harmonischen Signale mit Leistungsstärken, die innerhalb eines nichtlinearen Betriebsbereiches im Wesentlichen gleich zueinander sind, wobei der abstimmbare Aktivinduktor zum Abstimmen eines Wertes hiervon in der Lage ist, wobei der Oszillator (42) ausgelegt ist zum Verstärken der harmonischen Signale durch Überführung der Frequenz von harmonischen Signalen in Hochfrequenzbänder; und ein Filter (41), das ausgelegt ist zum selektiven Ausgeben von einem der von dem Oszillator ausgegebenen harmonischen Signale,
   **dadurch gekennzeichnet, dass** der Aktivinduktor umfasst:

   einen ersten Transistor (MP), der eine Source, die mit einer Spannungsquelle verbunden ist, und ein Gate, das mit einer ersten Vorspannung verbunden ist, aufweist;
   einen zweiten Transistor (M5), der einen Drain, der mit einem Drain des ersten Transistors verbunden ist, und ein Gate, das mit einer zweiten Vorspannung verbunden ist, aufweist;
   einen dritten Transistor (M6), der einen Drain, der mit einer Source des zweiten Transistors verbunden ist, und eine Source, die mit Masse verbunden ist, aufweist;
   einen vierten Transistor (MN), der einen Drain, der mit einem Gate des dritten Transistors verbunden ist, eine Source, die mit Masse verbunden ist, und ein Gate, das mit einer dritten Vorspannung verbunden ist, aufweist;
   einen fünften Transistor (M4), der eine Source, die mit dem Drain des vierten Transistors verbunden ist, und einen Drain, der mit der Spannungsquelle verbunden ist, aufweist; und
   einen ersten abstimmbaren Widerstand ($R_f$'), der zwischen dem Drain des ersten Transistors und einem Gate des fünften Transistors angeordnet ist und einen ersten Widerstand ($R_f$) und einen sechsten Transistor (MR) umfasst.

2. Signalgenerator nach Anspruch 1, wobei der erste Widerstand zwischen dem Drain des ersten Transistors und dem Gate des fünften Transistors angeordnet ist und der sechste Transistor einen Drain, der mit dem Drain des ersten Transistors verbunden ist, eine Source, die mit dem Gate des fünften Transistors verbunden ist, und ein Gate, das mit einer vierten Vorspannung verbunden ist, aufweist.

3. Signalgenerator nach einem der Ansprüche 1 bis 2, wobei der Oszillator umfasst:

   einen siebten Transistor, der eine Basis, die mit dem abstimmbaren Aktivinduktor verbunden ist, aufweist;
   einen ersten Kondensator, der zwischen dem abstimmbaren Aktivinduktor und dem siebten Transistor angeordnet ist;
   einen dritten Widerstand, der zwischen einer fünften Vorspannung und der Basis des Transistors angeordnet ist;
   einen zweiten Kondensator, der zwischen der Basis des siebten Transistors und einem Emitter des siebten Transistors angeordnet ist;
   einen dritten Kondensator, der zwischen Masse und dem zweiten Kondensator angeordnet ist;
   eine erste Stromquelle, die zwischen dem Emitter des siebten Transistors und Masse angeordnet ist;
   einen ersten Induktor, der zwischen einer Spannungsquelle und einem Kollektor des siebten Transistors angeordnet ist; und
   einen vierten Kondensator, der zwischen dem Kollektor des siebten Transistors und einem Ausgabeanschluss angeordnet ist.

4. Signalgenerator nach Anspruch 3, wobei das Filter eine Filterung unter Verwendung des ersten Induktors und eines ersten veränderlichen Kondensators, der zwischen dem Kollektor des siebten Transistors und Masse angeordnet ist, durchführt.

5. Signalgenerator nach einem der Ansprüche 1 bis 4, wobei der Oszillator umfasst:

   einen achten Transistor, der eine Basis aufweist, die zwischen dem abstimmbaren Aktivinduktor und einer sechsten Vorspannung angeordnet ist;
   einen fünften Kondensator, der zwischen dem abstimmbaren Aktivinduktor und dem achten Transistor angeordnet ist;
   einen zweiten veränderlichen Kondensator, der zwischen der Basis des achten Transistors und einem Emitter des achten Transistors angeordnet ist;
einen dritten veränderlichen Kondensator, der zwischen dem zweiten veränderlichen Kondensator und Masse angeordnet ist;
einen vierten Widerstand, der zwischen dem Emitter des achten Transistors und Masse angeordnet ist;
einen zweiten Induktor, der zwischen der Spannungsquelle und dem Kollektor des achten Transistors angeordnet ist; und
einen sechsten Kondensator, der zwischen dem Kollektor des achten Transistors und dem Ausgabeanschluss angeordnet ist.

**6.** Signalgenerator nach Anspruch 5, wobei das Filter eine Filterung unter Verwendung des zweiten Induktors und eines vierten veränderlichen Kondensators, der zwischen dem Emitter des achten Transistors und Masse angeordnet ist, durchführt.

**Revendications**

**1.** Générateur de signaux comprenant une inductance active pour générer des signaux harmoniques et un oscillateur pour produire en sortie les signaux harmoniques générés par l'inductance active,

- dans lequel le générateur de signaux est un générateur de signaux à bande ultra-large, l'inductance active, appelée TAI, inductance active accordable, étant adaptée à générer les signaux harmoniques dont les amplitudes de puissance sont sensiblement égales les unes aux autres dans une plage de fonctionnement non-linéaire, l'inductance active accordable pouvant être accordée sur une valeur de celle-ci, l'oscillateur (42) est adapté à amplifier les signaux harmoniques en faisant transiter les fréquences des signaux harmoniques dans des bandes de hautes fréquences ; et un filtre (41) est adapté à délivrer sélectivement en sortie un des signaux harmoniques produits en sortie de l'oscillateur,
- **caractérisé en ce que** l'inductance active comprend :
- un premier transistor (MP) dont la source est connectée à une source de tension et la grille est connectée à une première tension de polarisation ;
- un deuxième transistor (M5) dont le drain est connecté au drain du premier transistor et la grille est connectée à une deuxième tension de polarisation ;
- un troisième transistor (M6) dont le drain est connecté à la source du deuxième transistor et la source est connectée à la masse ;
- un quatrième transistor (MN) dont le drain est connecté à la grille du troisième transistor, la source est connectée à la masse et la grille est connectée à une troisième tension de polarisation ;
- un cinquième transistor (M4) dont la source est connectée au drain du quatrième transistor et le drain est connecté à la source de tension ; et
- une première résistance accordable ($R_f'$) interposée entre le drain du premier transistor et la grille du cinquième transistor et constituée par une première résistance ($R_f$) et un sixième transistor (MR).

**2.** Générateur de signaux selon la revendication 1, dans lequel la première résistance est interposée entre le drain du premier transistor et la grille du cinquième transistor et le sixième transistor comporte un drain connecté au drain du premier transistor, une source connectée à la grille du cinquième transistor et une grille connectée à une quatrième tension de polarisation.

**3.** Générateur de signaux selon l'une des revendications 1 à 2, dans lequel l'oscillateur comprend : - un septième transistor dont la base est connectée à l'inductance active accordable ;

- un premier condensateur interposé entre l'inductance active accordable et le septième transistor ;
- une troisième résistance interposée entre une cinquième tension de polarisation et la base du transistor ;
- un deuxième condensateur interposé entre la base du septième transistor et l'émetteur du septième transistor ;
- un troisième condensateur interposé entre la masse et le deuxième condensateur ;
- une première source de courant interposée entre l'émetteur du septième transistor et la masse ;
- une première inductance interposée entre la source de tension et le collecteur du septième transistor ; et
- un quatrième condensateur interposé entre le collecteur du septième transistor et un point de sortie.

**4.** Générateur de signaux selon la revendication 3, dans lequel le filtre effectue un filtrage en utilisant la première inductance et un premier condensateur variable interposés entre le collecteur du septième transistor et la masse.

**5.** Générateur de signaux selon l'une des revendications 1 à 4, dans lequel l'oscillateur comprend : - un huitième transistor dont la base est interposée entre l'inductance active accordable et une sixième tension de polarisation ;

- un cinquième condensateur interposé entre l'inductance active accordable et le huitième transistor ;
- un deuxième condensateur variable interposé entre la base du huitième transistor et l'émetteur du huitième transistor ;
- un troisième condensateur variable interposé entre le deuxième condensateur variable et la masse ;
- une quatrième résistance interposée entre l'émetteur du huitième transistor et la masse ;
- une deuxième inductance interposée entre la source de tension et le collecteur du huitième transistor ; et
- un sixième condensateur interposé entre le collecteur du huitième transistor et le point de sortie.

**6.** Générateur de signaux selon la revendication 5, dans lequel le filtre effectue un filtrage en utilisant la deuxième inductance et un quatrième condensateur variable interposés entre l'émetteur du huitième transistor et la masse.

FIG.1

FIG.2

FIG.3

FIG.4

FIG.5

FIG.6

FIG.7

FIG.8

Transfer Function of
Resonant Load

FREQUENCY

$f_0$   $2f_0$   $3f_0$   $4f_0$

FIG.9

FIG.10

FIG.11

FIG.12

**EP 1 689 074 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5821825 A
- JP 08065050 A
- US 5347238 A